**Europäisches Patentamt**

**European Patent Office**

**Office européen des brevets**

(19)

(11) Veröffentlichungsnummer: **0 075 694**
**B1**

(12) **EUROPÄISCHE PATENTSCHRIFT**

(45) Veröffentlichungstag der Patentschrift:
**10.12.86**

(21) Anmeldenummer: **82107298.0**

(22) Anmeldetag: **11.08.82**

(51) Int. Cl.⁴: **H 01 L 27/14, H 04 N 3/15**

(54) **Zweidimensionaler Halbleiter-Bildsensor mit hoher Packungsdichte.**

(30) Priorität: **25.09.81 DE 3138295**

(43) Veröffentlichungstag der Anmeldung:
**06.04.83 Patentblatt 83/14**

(45) Bekanntmachung des Hinweises auf die Patenterteilung:
**10.12.86 Patentblatt 86/50**

(84) Benannte Vertragsstaaten:
**BE FR GB IT NL**

(56) Entgegenhaltungen:
**FR - A - 2 134 042**
**FR - A - 2 319 182**

**IEEE JOURNAL OF SOLID-STATE CIRCUITS, Band SC-15, Nr. 4, August 1980, Seiten 747-752, IEEE, New York, US; S. OHBA u.a.: "MOS area sensor: Part II - Low noise MOS area sensor with antiblooming photodiodes"**

(73) Patentinhaber: **Siemens Aktiengesellschaft Berlin und München, Wittelsbacherplatz 2, D-8000 München 2 (DE)**

(72) Erfinder: **Herbst, Herbert, Dr., Anechostrasse 29a, D-8000 München 82 (DE)**

ACTORUM AG

**Beschreibung**

Die Erfindung bezieht sich auf einen zweidimensionalen Halbleiter-Bildsensor nach dem Oberbegriff des Anspruchs 1.

Ein Bildsensor dieser Art ist aus dem IEEE Journal of Solid-State Circuits, Vol. SC-15, No. 4, August 1980, Seiten 747 bis 752, bekannt. Er weist aus Fotodioden und Auswahltransistoren bestehende Sensorelemente auf, die in 244 übereinander liegenden Zeilen zu jeweils 320 Elementen auf einer Bildfläche von 8,8 mm × 6,6 mm integriert sind. Unter Bildfläche wird hierbei jene Halbleiterfläche verstanden, auf die eine elektronisch aufzunehmende Abbildung projiziert wird.

Der Erfindung liegt die Aufgabe zugrunde, einen Bildsensor der eingangs genannten Art anzugeben, der die bekannten Bildsensoren im Hinblick auf die Packungsdichte der Sensorelemente noch übertrifft. Dies wird durch eine Ausbildung gemäss dem kennzeichnenden Teil des Anspruchs 1 erreicht.

Der mit der Erfindung erzielbare Vorteil besteht insbesondere darin, dass die Abmessung der Bildfläche des Bildsensors bei einer vorgegebenen Anzahl von aufintegrierten Sensorelementen in Richtung der Spaltenleitungen wesentlich kleiner ist als bei den bekannten Bildsensoren oder dass bei vorgegebenen Abmessungen der Bildfläche wesentlich mehr Sensorelemente aufintegriert werden können.

Die Ansprüche 2 und 3 sind auf bevorzugte Weiterbildungen der Erfindung gerichtet.

Die Erfindung wird nachfolgend anhand der Zeichnung näher erläutert. Dabei zeigt:

Fig. 1 einen Teil eines erfindungsgemäss ausgebildeten Bildsensors im Querschnitt und

Fig. 2 eine Draufsicht auf einen Bildsensor nach der Erfindung im Bereich einiger nebeneinander liegender Sensorelemente.

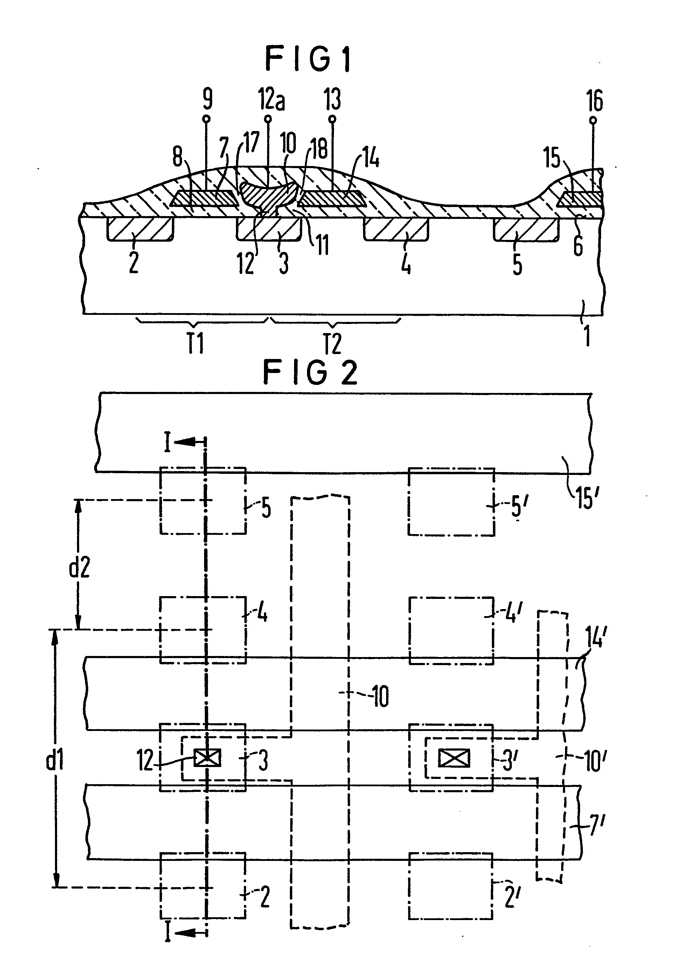

In Figur 1 ist ein Halbleiterkörper 1 eines ersten Leitungstyps, z.B. aus p-dotiertem Silizium, im Schnitt dargestellt. In diesen sind Halbleitergebiete 2 bis 5 eines zweiten Leitungstyps, z.B. $n^+$-dotierte Gebiete, eingefügt, die sich bis zu einer Grenzfläche 6 des Halbleiterkörpers 1 erstrecken. Die Gebiete 2, 4 und 5 stellen jeweils in Verbindung mit 1 Fotodioden dar. Das Gebiet 2 ist ausserdem ein Anschlussgebiet eines Auswahltransistors T1, dessen zweites Anschlussgebiet durch 3 gebildet wird. T1 weist ein mit einem Anschluss 9 versehenes Gate 7 aus elektrisch leitendem Material, z.B. polykristallinem Silizium, auf, das durch eine dünne Schicht 8 aus elektrisch isolierendem Material, z.B. SiO$_2$, von der Grenzfläche 6 getrennt ist. Das Anschlussgebiet 3 von T1 steht mit einer Spaltenleitung 10 in Verbindung. Diese ist durch eine elektrisch isolierende Schicht 11 von der Grenzfläche 6 getrennt. Lediglich im Bereich eines Kontaktlochs 12 wird das Anschlussgebiet 3 von der Spaltenleitung 10 kontaktiert. 12a bezeichnet einen Anschluss der Spaltenleitung 10.

Die Fotodiode 1, 2 und der Auswahltransistor T1 bilden ein Sensorelement, bei dem sich unter Lichteinwirkung im Gebiet 2 Ladungsträger ansammeln, die beim Anlegen jeweils einer positiven Spannung an 9 und 12a über den leitend geschalteten Transistor T1 und die Spaltenleitung 10 ausgelesen werden.

In analoger Weise bildet das Gebiet 4 zusammen mit 1 eine weitere Fotodiode und zusammen mit dem Anschlussgebiet 3 und einem mit einem Anschluss 13 versehenen Gate 14 einen weiteren Auswahltransistor T2. Eine Auslesung der in 4 unter Lichteinwirkung gespeicherten Ladungsträger geschieht durch Anlegen jeweils einer positiven Spannung an 13 und 12a über die Spaltenleitung 10.

Eine weitere Fotodiode wird in Fig. 1 durch das Gebiet 5 in Verbindung mit dem Haltleiterkörper 1 gebildet, wobei der zugehörige Auswahltransistor durch ein Gate 15 angedeutet ist, das mit einem Anschluss 16 versehen ist.

Die in Fig. 2 gezeigte Draufsicht auf den Halbleiterkörper 1 lässt die laterale Ausbildung der in Fig. 1 dargestellten Struktur erkennen. Der Schnitt von Fig. 1 verläuft längs der vertikalen Linie I–I von Fig. 2, wobei auch die Halbleitergebiete 2 bis 5 auf dieser vertikalen Linie bzw. in einer Spalte des Halbleiter-Bildsensors liegen. Die Zeilenleitungen 7′, 14′ und 15′ verlaufen in horizontalen Richtungen, während die Spaltenleitung 10, die von den Zeilenleitungen durch isolierende Zwischenschichten, z.B. 17 und 18, getrennt ist und beispielsweise aus Aluminium besteht, in Fig. 2 in vertikaler Richtung verläuft. Der in Fig. 1 dargestellte Teil der Spaltenleitung 10 ist in Fig. 2 als horizontal verlaufender Ansatz erkennbar, der im Bereich des Kontaktlochs 12 mit dem Gebiet 3 verbunden ist. Die Gates 7 und 14 (Fig. 1) stellen jeweils diejenigen Abschnitte der Zeilenleitungen 7′ und 14′ (Fig. 2) dar, die die Halbleiterbereiche zwischen den Gebieten 2 und 3 bzw. 3 und 4 überdecken.

Von den den Zeilenleitungen 7′ und 14′ zugeordneten Sensorelementen sind die beiden, die in Fig. 2 der linksseitig gezeigten Spalte angehören, in der Weise zusammengefasst, dass ihre Auswahltransistoren ein gemeinsames Anschlussgebiet 3 aufweisen, das über das Kontaktloch 12 mit der Spaltenleitung 10 verbunden ist.

Im rechten Teil der Fig. 2 sind weitere Halbleitergebiete 2′ bis 5′ des zweiten Leitungstyps angedeutet, die in einer weiteren Spalte des Bildsensors liegen. In dieser sind ebenfalls die den einander benachbarten Zeilenleitungen 7′ und 14′ zugeordneten Sensorelemente in der Weise zusammengefasst, dass ihre Auswahltransistoren ein gemeinsames Anschlussgebiet 3′ aufweisen, das über ein Kontaktloch 12′ mit einer dieser Spalte zugeordneten Spaltenleitung 10′ verbunden ist.

Der Abstand d1 zwischen den Mittelpunkten der Fotodioden zweier in der beschriebenen Weise zusammengefasster Sensorelemente ist durch die vertikalen Abmessungen des Kontaktlochs 12, des Gebiets 3 und die Breite der Zeilenleitungen 7′ und 14′ mitbestimmt. Die Fotodiode 5 des sich in derselben Spalte anschliessenden Sensorelements kann einen Mittelpunktabstand d2 zu der Fotodiode 4 haben, der kleiner ist als d1.

In Abweichung von der bisher beschriebenen Ausführungsform kann die Spaltenleitung 10 auch durch eine in den Halbleiterkörper 1 eingefügte, insbesondere eindiffundierte, $n^+$-66-dotierte Leitung ersetzt sein, die mit dem gemeinsamen Anschlussgebiet 3 der Auswahltransistoren T1 und T2 in Verbindung steht.

**Patentansprüche**

1. Zweidimensionaler Halbleiter-Bildsensor mit auf einem dotierten Halbleiterkörper (1) eines ersten Leitungstyps integrierten, in Zeilen und Spalten angeordneten Sensorelementen, bei dem die Sensorelemente jeweils einen Feldeffekt-Auswahltransistor (T1) mit isoliertem Gate (7) und eine Fotodiode aufweisen, die aus einem in den Halbleiterkörper eingefügten Halbleitergebiet eines zweiten Leitungstyps besteht (2), und bei dem Zeilenleitungen (7′, 14′) und Spaltenleitungen (10, 10′) vorgesehen sind, von denen die Zeilenleitungen (7′, 14′) mit den Gates (7, 14) der Auswahltransistoren (T1, T2) beschaltet sind und die Spaltenleitungen (10, 10′) mit Anschlussgebieten der Auswahltransistoren verbunden sind, dadurch gekennzeichnet, dass die Sensorelemente benachbarter Zeilen (7′, 14′) spaltenweise derart zusammengefasst sind, dass die Anschlussgebiete der Auswahltransistoren (T1, T2) zweier der gleichen Spaltenleitung (10) zugeordneter Sensorelemente aus einem einzigen, beiden Sensorelementen gemeinsamen Halbleitergebiet (3) bestehen, das mit der Spaltenleitung (10) verbunden ist.

2. Zweidimensionaler Halbleiter-Bildsensor nach Anspruch 1, dadurch gekennzeichnet, dass die Spaltenleitung (10) auf einer auf dem Halbleiterkörper (1) aufgebrachten isolierenden Schicht (11) angeordnet ist und im Bereich eines Kontaktlochs (12) mit den beiden Sensorelementen gemeinsamen Halbleitergebiet (3) verbunden ist.

3. Zweidimensionaler Halbleiter-Bildsensor nach Anspruch 1 oder 2, dadurch gekennzeichnet, dass das beiden Sensorelementen gemeinsame Halbleitergebiet (3) mit einem ansatzartigen Teil der Spaltenleitung (10) verbunden ist, das in Richtung der Zeilenleitungen (7′, 14′) verläuft.

**Claims**

1. A two-dimensional semiconductor image sensor with sensor elements which are arranged in rows and columns and are integrated on a doped semiconductor body (1) of a first conductivity type, where the sensor elements each comprise a field effect selector transistor (T1) with an insulated gate (7) and a photo-diode which consists of a semiconductor zone of a second conductivity type (2) which is inserted into the semiconductor body, and where row lines (7′, 14′) and column lines (10, 10′) are provided, of which the row lines (7′, 14′) are connected to the gates (7, 14) of the selector transistors (T1, T2) and the column lines (10, 10′) are connected to terminal zones of the selector transistors, characterised in that the sensor elements of adjacent rows (7′, 14′) are combined in columns in such a way that the terminal zones of the selector transistors (T1, T2) of two sensor elements assigned to the same column line (10) consist of a single semiconductor zone (3) which is common to both sensor elements and which is connected to the column line (10).

2. A two-dimensional semiconductor image sensor as claimed in Claim 1, characterised in that the column line (10) is arranged on an insulating layer (11) which is applied to the semiconductor body (1) and in the region of a contact hole (12) is connected to the semiconductor zone (3) which is common to both sensor elements.

3. A two-dimensional semiconductor image sensor as claimed in Claim 1 or Claim 2, characterised in that the semiconductor zone (3) which is common to both sensor elements is connected to a shoulder-like part of the column line (10) which extends in the direction of the row lines (7′, 14′).

**Revendications**

1. Capteur d'images bidimensionnel à semiconducteurs, comprenant des éléments capteurs intégrés sur un corps semi-conducteur dopé (1) d'un premier type de conductivité, qui sont disposés en lignes et colonnes, dans lequel les éléments capteurs possèdent chacun un transistor à effet de champ de sélection (T1) à grille isolée (7) et une photodiode, formée par une zone de semi-conducteur (2) d'un second type de conductivité, insérée dans le corps semi-conducteur, et dans lequel sont prévues des connexions de lignes (7′, 14′) et des connexions de colonnes (10, 10′), dont les connexions de lignes (7′, 14′) sont branchées sur les grilles (7, 14) des transistors de sélection (T1, T2) et les connexions de colonnes (10, 10′) sont reliées à des zones de raccordement des transistors de sélection, caractérisé en ce que les éléments capteurs de lignes voisines (7′, 14′) sont réunis, dans le sens des colonnes, de manière que les zones de raccordement des transistors de sélection (T1, T2) de deux éléments capteurs coordonnés à la même connexion de ligne, soient constituées par une seule zone de semi-conducteur (3) commune aux deux éléments capteurs et qui est reliée à la connexion de colonne (10).

2. Capteur selon la revendication 1, caractérisé en ce que la connexion de colonne (10) est disposée sur une couche isolante (11) appliquée sur le corps semi-conducteur (1) et est reliée à la zone de semi-conducteur (3) commune aux deux éléments capteurs dans la région d'un trou de contact (12).

3. Capteur selon la revendication 1 ou 2, caractérisé en ce que la zone de semi-conducteur (3) commune aux deux éléments capteurs est reliée à une partie de la connexion de colonne (10) s'étendant en direction des connexions de lignes (7′, 14′).

0 075 694

# F I G 1

# F I G 2